(19) **Europäisches Patentamt**
**European Patent Office**
**Office européen des brevets**

(11) **EP 1 963 812 B1**

(12) **EUROPÄISCHE PATENTSCHRIFT**

(45) Veröffentlichungstag und Bekanntmachung des Hinweises auf die Patenterteilung:
**30.11.2011 Patentblatt 2011/48**

(21) Anmeldenummer: **06829651.6**

(22) Anmeldetag: **15.12.2006**

(51) Int Cl.:
***G01M 11/02*** *(2006.01)*

(86) Internationale Anmeldenummer:
**PCT/EP2006/012103**

(87) Internationale Veröffentlichungsnummer:
**WO 2007/079904 (19.07.2007 Gazette 2007/29)**

(54) **VERFAHREN UND VORRICHTUNG ZUR UNTERSUCHUNG DES ABBILDUNGSVERHALTENS EINER ABBILDUNGSOPTIK**

METHOD AND DEVICE FOR ANALYSING THE IMAGING BEHAVIOUR OF AN OPTICAL IMAGING ELEMENT

PROCÉDÉ ET DISPOSITIF D'ANALYSE DE LA MÉTHODE D'AFFICHAGE D'UNE OPTIQUE D'IMAGERIE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **22.12.2005 DE 102005062237**

(43) Veröffentlichungstag der Anmeldung:
**03.09.2008 Patentblatt 2008/36**

(73) Patentinhaber: **Carl Zeiss SMS GmbH**
**07745 Jena (DE)**

(72) Erfinder:
• **GREIF-WÜSTENBECKER, Jörn**
**1030 Wien (AT)**

• **STRÖSSNER, Ulrich**
**07745 Jena (DE)**

(74) Vertreter: **Geyer, Fehners & Partner**
**Patentanwälte**
**Sellierstrasse 1**
**07745 Jena (DE)**

(56) Entgegenhaltungen:
| | |
|---|---|
| EP-A2- 1 615 062 | WO-A2-03/001272 |
| WO-A2-03/076891 | US-A- 5 298 972 |
| US-A- 5 396 329 | US-A- 5 828 500 |
| US-A1- 2004 114 150 | US-B1- 6 266 141 |
| US-B2- 6 665 059 | |

**Beschreibung**

Die Erfindung betrifft ein Verfahren zur Untersuchung des Abbildungsverhaltens einer ersten Abbildungsoptik, bei dem ein Objekt durch eine zweite Abbildungsoptik in eine Bildebene abgebildet wird und Licht in der Bildebene in Pixeln ortsaufgelöst detektiert wird, wobei sich die erste und zweite Abbildungsoptik in mindestens einer Abbildungseigenschaft unterscheiden, wobei für jedes Pixel Werte für die Intensität als eine erste Eigenschaft des Lichts bestimmt und in Bildpunkten gespeichert werden, und wobei eine Serie von Bildern erzeugt wird.

Die Erfindung betrifft auch eine Vorrichtung zur Untersuchung des Abbildungsverhaltens einer ersten Abbildungsoptik. Eine solche Vorrichtung umfaßt eine zweite Abbildungsoptik, durch die ein Objekt in eine Bildebene abgebildet wird, und die sich von der ersten Abbildungsoptik in mindestens einer Abbildungseigenschaft unterscheidet, einen ortsauflösenden Detektor mit Pixeln, mit dem Licht in der Bildebene in den Pixeln detektiert wird, sowie ein Speichermodul, in welchem ortsaufgelöst Werte für die Intensität als eine erste Eigenschaft des Lichts in Bildpunkten gespeichert werden, wobei die Vorrichtung eine Serie von Bilder erzeugt. Die Erfindung bezieht sich auf das Problem, daß im Stand der Technik Abhängigkeiten von einer zweiten Eigenschaft des Lichts - bei der es sich beispielsweise um die Farbe oder die Polarisation handeln kann - bei der Emulation nur unvollständig, beispielsweise summarisch berücksichtigt werden können.

Bei der Emulation der Abbildungseigenschaften optischer Systeme kann es dabei zu Ungenauigkeiten in der Emulation kommen. Einige Fehler machen sich beispielsweise besonders bemerkbar, wenn man mit einer niederaperturigen Abbildungsoptik eine hochaperturige Abbildungsoptik emuliert. Bisher wurden beispielsweise polarisierende Elemente wie Polarisatoren oder Gitter im wesentlichen anhand ihrer integralen Wirkung untersucht und bewertet. Mit der Entwicklung von mikro- oder nanostrukturierten optischen Bauelementen gewinnt jedoch die Bestimmung der lokalen optischen Eigenschaften immer mehr an Bedeutung für die Weiterentwicklung und Verbesserung von Fertigungsprozessen und der Gewährleistung der Produktqualität. Als Beispiel für solche optischen Bauelemente sei hier ein diffraktiv optisches Element (DOE) erwähnt, wie es beispielsweise im in der WO 03/001272 A3 beschriebenen Hybridobjektiv verwendet wird. Die optische Wirkung dieses DOE entsteht an den Stegen, die konzentrisch um die optische Achse angeordnet sind. Dabei ist der Abstand zwischen zwei Stegen nicht konstant, sondern variiert in Abhängigkeit vom Radius. Die Aufgabe dieses Elements ist eine dispersiv abbildende Farbkompensation innerhalb des Objektivs, wobei sich die optische Güte des Objektivs aus dem Zusammenwirken zwischen den refraktiven Linsen und dem DOE ergibt. Um nicht erst bei der Endmontage des Objektivs die optischen Eigenschaften des DOE beurteilen zu können, ist es wünschenswert, die optische Wirkung vorab im Detail zu studieren. Dies kann unabhängig von dem Objektiv erfolgen, oder aber auch durch Einbringen in den Strahlengang einer abbildenden Optik, z.B. einem Emulationsabbildungssystem als zweiter Abbildungsoptik zur Emulation des betreffenden Objektivs, der ersten Abbildungsoptik. Das Einbringen des DOE erfordert in der Regel eine Anpassung des Strahlengangs, beide Abbildungsoptiken unterscheiden sich zumindest darin. Außerdem kann die zweite Abbildungsoptik auch so ausgestaltet sein, daß sie das Objekt gegenüber dem Objektiv vergrößert oder verkleinert abbildet.

Ein anderes Beispiel für solche Bauelemente sind klassische lineare Beugungsgitter. Bei den beispielsweise in der Telekommunikation eingesetzten Gittern wird mit steigender Anzahl von Linienpaaren pro Flächeneinheit der Energieanteil und somit die Effizienz in der nullten Beugungsordnung erhöht. Mit steigender Linienzahl, d.h. kleineren Strukturgrößen, steigt beim Gitter die polarisierende Wirkung.

Auch bei Photolithographie-Scannern, bei denen der Trend zu immer höhern numerischen Aperturen und immer kleineren Maskenstrukturen geht, spielen Polarisationseffekte eine immer größere Rolle. Mit den bisher im Stand der Technik bekannten Emulationsabbildungsverfahren und -systemen lassen sich solche Polarisationseffekte jedoch nur unvollständig beschreiben, da die Polarisationswirkung nur summarisch, d.h. über die Bildfläche integriert, berücksichtigt wird.

Aus der WO 03/76891 sind ein Verfahren und eine Vorrichtung bekannt, mit denen Abbildungsfehler wie die Aberrationen einer ersten Abbildungsoptik - beispielsweise eines Projektionsobjektivs für die Photolithographie - vermessen werden können. Die Abbildungsoptik wird in ein zweites optisches System eingebracht, welches unter anderem über eine Beleuchtungseinrichtung, eine zweite Abbildungsoptik und einen ortsauflösenden Detektor verfügt. In den Strahlengang wird sowohl objektseitig als auch bildseitig gleichzeitig jeweils ein Gitter eingebracht. Die Gitter weisen aneinander angepaßte Strukturen in Form von Untergittern mit Strichmustern auf. Das objektseitig gelegene Gitter wird auf das bildseitige Gitter abgebildet, so daß die Abbildungen der Gitter sich auf dem Detektor überlagern und Moire-Muster erzeugen. Die Gitter sind rotier- und / oder verschiebbar gelagert. Die Störungen lassen sich bestimmen, indem Serien von Bildern mit verschiedenen Stellungen der Gitter aufgenommen und ausgewertet werden.

Aufgabe der vorliegenden Erfindung ist es daher, ein Verfahren und eine Vorrichtung der eingangs beschriebenen Art dahingehend weiterzuentwickeln, daß optische Eigenschaften und Faktoren, die das Abbildungsverhalten einer zu untersuchenden ersten Abbildungsoptik beeinflussen, besser berücksichtigt werden.

Diese Aufgabe wird bei einem Verfahren der eingangs beschriebenen Art gemäß Anspruch 1 dadurch gelöst, daß für jedes Pixel Werte für mindestens eine weitere, zweite Eigenschaft des Lichts bestimmt und in Bildpunkten gespeichert wird, die Serie von Bilder erzeugt wird, indem (a) ein Wertebereich der zweiten Eigenschaft in Teilbereiche zerlegt wird, (b) jedem Teilbereich ein Bild zugeordnet wird, und (c) den Bildpunkten jedes Bildes der entsprechende, gespeicherte Intensitätswert zugeordnet wird, falls der dem Bildpunkt zugeordnete Wert der zweiten Eigenschaft in dem jeweiligen Bild zugeordneten Teilbereich fällt, und ihnen andernfalls ein vorgegebener Intensitätswert zugeordnet wird. Dann werden die gespeicherten Werte in einem Emulationsschritt verarbeitet, indem die Serie von Bildern in eine Serie von Zwischenbildern umgewandelt wird, wobei für jedes der Zwischenbilder ein konstanter Wert der zweiten Eigenschaft in die Emulation eingeht. Der konstante Wert der zweiten Eigenschaft stammt aus dem jeweiligen Teilbereich und ist von den Werten der zweiten Eigenschaft für die jeweils anderen Zwischenbilder verschieden. Anschließend wird durch Kombination der Zwischenbilder ein Emulationsbild erzeugt, welches eine Abbildung des Objektes mit der ersten Abbildungsoptik unter Berücksichtigung der Abbildungseigenschaft und des Einflusses der zweiten Eigenschaft auf das Abbildungsverhalten emuliert.

Bei der Erzeugung einer Abbildung mit einem zu untersuchenden optischen Bauelement wird neben der Intensität noch eine weitere Eigenschaft, beispielsweise die Farbe oder die Polarisationswirkung für jeden Bildpunkt bestimmt, wozu im Stand der Technik bekannte Verfahren verwendet werden können. Wie auch die Intensität, so wird auch der Wert der zweiten Eigenschaft in der Regel in Abhängigkeit vom Ort variieren. Die Zerlegung in einzelne Bilder, für die der Wert der zweiten Eigenschaft, der in das Auswerteverfahren bzw. den Emulationsschritt als Parameter eingeht, jeweils konstant ist, ermöglicht es, den Fehler, der gegenüber einer Auswertung bzw. Emulation - wie sie dem Stand der Technik entspricht - mit einem über das gesamte Bild gemittelten Wert für die zweite Eigenschaft gemacht worden wäre, zu verringern. Je mehr und je engere Teilbereiche erzeugt werden, desto geringer wird der Fehler.

Die Teilbereiche können dabei aneinander angrenzend gewählt werden, für die Verarbeitung und den Bezug zur Praxis ist es jedoch vorteilhaft, einander zumindest teilweise überlappende Teilbereiche zu wählen, wobei sich bevorzugt nur benachbarte Teilbereiche überlappen. Eine Aufteilung in Teilbereiche kann auf diese Weise beispielsweise mit Hilfe von trigonometrischer Funktionen erfolgen - die Durchlässigkeit eines Farbfilters oder Polarisators zum Beispiel wird durch das Quadrat einer Sinusfunktion beschrieben.

Als vorgegebenen Intensitätswert wählt man vorzugsweise 0, d.h. sobald der Wert der zweiten Eigenschaft nicht mehr in den einem Zwischenbild zugeordneten Teilbereich fällt, wird der Intensitätswert für dieses Zwischenbild und den betreffenden Bildpunkt zu Null gesetzt. Dabei ist es zweckmäßig, wenn Bilder, Zwischenbilder und das Emulationsbild jeweils die gleiche Größe aufweisen, da so die Verarbeitung erleichtert wird. Jedes Bild, Zwischenbild und das Emulationsbild verfügen also bevorzugt über die gleiche Anzahl von Bildpunkten bzw. Bildpunktzeilen und -spalten. Selbstverständlich lassen sich auch verschiedene Größen verwenden, wenn eine entsprechende Anpassung erfolgt.

Zur Kombination der Zwischenbilder zum Emulationsbild gibt es verschiedene Möglichkeiten. Eine besonders einfache besteht darin, die Zwischenbilder für jeden Bildpunkt zu addieren. Eine andere, ebenfalls einfach zu realisierende Möglichkeit besteht darin, für jeden Bildpunkt den Mittelwert der Intensitätswerte der Zwischenbilder zu bilden und so das Emulationsbild zu erzeugen.

Insbesondere dann, wenn die Teilbereiche einander überlappen, ist es vorteilhaft, die Intensitätswerte bei der Zuordnung zu einem Bild der Serie zu wichten. Bevorzugt erfolgt diese Wichtung so, daß die Summe der für einen Bildpunkt gewichteten Intensitätswerte bei Zuordnung zu mehreren Teilbereichen den ursprünglichen Intensitätswerten des Bildpunktes entspricht.

Als zweite Eigenschaft kommen verschiedene Eigenschaften des zu detektierenden Lichtes in Frage, eine wichtige Eigenschaft ist beispielsweise die Farbe. Hier bestimmt und speichert man für jeden Bildpunkt vorzugsweise die Wellenlänge und/oder den Farbsättigungsgrad. Dies läßt sich beispielsweise erzielen, indem in jedem Bildpunkt die Farben unabhängig voneinander detektiert werden, indem beispielsweise ein wellenlängenselektiver Detektor mit entsprechend vorgeschalteter Optik verwendet wird, der für jeden Farbbereich - Rot, Grün und Blau - getrennt detektiert. Eine andere Möglichkeit besteht darin, die Serie von Einzelbildern mit Hilfe von Farbfiltern, die in den Strahlengang eingebracht werden, zu erzeugen.

Eine besonders bevorzugte Wahl der zweiten Eigenschaft ist der Polarisationszustand, der z.B. bei der Emulation hochaperturiger Optiken an Einfluß gewinnt. Da dieser nicht wie die Intensität direkt auf einer CCD detektierbar ist, müssen für jeden Bildpunkt der Polarisationsgrad und/oder die Polarisationsrichtung durch Messung bestimmt und gespeichert werden. Zur ortsaufgelösten Bestimmung der Polarisation können beispielsweise ortsaufgelöst die Stokes-Parameter, die das polarisierende optische Element charakterisieren, bestimmt werden. Diese Methode ist beispielsweise von H. W. Berry et al. in Applied Optics 16, 3200 (1977) beschrieben. Anschließend kann die Serie von Bildern rechnerisch anhand der gespeicherten Werte erzeugt werden.

Eine andere Möglichkeit besteht darin, die Serie von Bildern zu erzeugen, indem das Licht vor der Detektion durch einen Polarisator geleitet wird, wobei die Teilbereiche durch die verschiedenen Stellungen des Polarisators festgelegt werden. In einem solchen Polarisator ist bereits eine natürliche Wichtungsfunktion inkorporiert, die im wesentlichen dem Quadrat einer Sinusfunktion entspricht. Die Teilbereiche sind daher in der Regel recht groß und überlappen sich. Auch eine Kombination von Polarisator und rechnerischer Erzeugung der Bilder ist möglich.

Erzeugt man die Serie von Bildern rechnerisch anhand der gespeicherten Werte, so läßt sich diese natürliche Wichtungsfunktion ebenfalls verwenden, es stehen jedoch noch eine große Anzahl und in der Regel günstigere Wichtungsfunktionen zur Verfügung. In einer vorteilhaften Ausgestaltung des Verfahrens werden die Intensitätswerte beispielsweise mit einer Funktion

$$ C \cdot |\varphi - \theta| $$

gewichtet, wenn der einem Bildpunkt zugeordnete Polarisationswinkel $\theta$ in den Teilbereich fällt, wobei C eine Konstante und $\varphi$ der Polarisationwinkel im Zentrum des entsprechenden Teilbereichs ist. Liegt der einem Bildpunkt zugeordnete Polarisationswinkel außerhalb des Teilbereichs, so wird dementsprechend einem Bildpunkt der vorgegebene Intensitätswert, also beispielsweise Null, zugeordnet. Mit dieser Dreiecksfunktion, deren Steigung durch eine entsprechende Wahl der Konstante beeinflußt werden kann, läßt sich eine Wichtung derart erzielen, daß für jedes Bild die Polarisation als im Wesentlichen homogen angenommen werden kann. Dabei ist die Genauigkeit um so höher, je höher die Anzahl der Teilbereiche gewählt wird, wobei jedoch die Anzahl der Teilbereiche mit der Dauer der Emulation abgestimmt werden muß, da mit steigender Anzahl von Bildern der Emulationsschritt länger dauert. Als guter Kompromiß hat sich beispielsweise eine Wahl von 6, 8 oder 12 Teilbereichen herausgestellt. Grundsätzlich ist die Zahl der Teilbereiche frei wählbar. Um die eben beschriebene Dreiecksfunktion im Auswerteverfahren bzw. Emulationsschritt besser handhabbar zu machen, kann sie außerdem beispielsweise mit einer Glättungsfunktion gefaltet werden, so daß sie mindestens einmal stetig differenzierbar wird.

Eine andere Möglichkeit besteht in der Wichtung der Intensitätswerte mit der Funktion

$$ C \cdot \cos^2(\varphi - \theta) \quad , $$

wenn der einem Bildpunkt zugeordnete Polarisationswinkel $\theta$ in den Teilbereich fällt, wobei C eine Konstante und $\theta$ der Polarisationswinkel im Zentrum des entsprechenden Teilbereichs ist. Diese Funktion entspricht bei angepaßter Wahl der Konstanten im wesentlichen einer gerundeten Dreiecksfunktion.

Für die mit diesen Funktionen erzeugten Bilder der Serie ist die Polarisation über das Bildfeld näherungsweise konstant. Die Bilder können dann im Auswerteverfahren bzw. im Emulationsschritt, wo eine Ortsabhängigkeit der Polarisation nicht berücksichtigt wird, im wesentlichen fehlerfrei verarbeitet werden.

In einer bevorzugten Ausgestaltung der Erfindung wird unpolarisiertes Licht, zu dem auch zirkular polarisiertes Licht zählen soll, ebenfalls berücksichtigt. Dies wird erreicht, indem einem der Teilbereiche ausschließlich der Polarisationsgrad Null zugeordnet wird und dem diesem Teilbereich zugeordneten Bild die Intensitätswerte von detektiertem, unpolarisierten Licht zugeordnet werden. Die dem Bild mit dem Polarisationsgrad Null zuordneten Intensitätswerte können dann auf andere Bilder aufgeteilt und zu den entsprechenden Intensitätswerten addiert werden. Die Aufteilung erfolgt dabei bevorzugt gleichmäßig. Alternativ kann dieses Bild auch getrennt verarbeitet werden, entweder als Ganzes oder indem es seinerseits wiederum auf verschiedene Bilder aufgeteilt wird.

In einer besonders bevorzugten Ausgestaltung der Erfindung wird als erste Abbildungsoptik ein Photolithographie-Scanner und als zweite Abbildungsoptik eine Emulationsabbildungsoptik zur Emulation des Photolithographie-Scanners verwendet. Bei dem Photolithographie-Scanner handelt es sich um eine Abbildungsoptik mit einer sehr hohen numerischen Apertur, während es sich bei der Emulationsabbildungsoptik um eine Optik mit einer niedrigen numerischen Apertur handelt. Mit der vorangehend beschriebenen Erfindung lassen sich auf diese Weise im Emulationsschritt beispielsweise Verfahren zur Emulation von abbildungsoptischen Effekten bei hohen numerischen Aperturen, wie sie in der deutschen Patentanmeldung 10 2004 033 603.2 beschrieben sind, ortsaufgelöst emulieren, obwohl die dort beschriebenen Verfahren eine Ortsabhängigkeit der Polarisation nicht berücksichtigen.

Die Erfindung betrifft auch eine Vorrichtung zur Untersuchung des Abbildungsverhaltens einer ersten Abbildungsoptik. Bei einer solchen Vorrichtung, wie sie oben beschrieben wurde, wird die Aufgabe gemäß Anspruch 17 dadurch gelöst, daß im Speichermodul ortsaufgelöst Werte für mindestens eine weitere, zweite Eigenschaft des Lichts in Bildpunkten gespeichert werden und die Vorrichtung die Serie von Bilder erzeugt, indem (a) ein Wertebereich der zweiten Eigenschaft in Teilbereiche aufgeteilt wird, (b) jedem Teilbereich ein Bild zugeordnet wird, und (c) den Bildpunkten jedes Bildes der entsprechende, gespeicherte Intensitätswert zugeordnet wird, falls der dem Bildpunkt zugeordnete Wert der zweiten Eigenschaft in den dem jeweiligen Bild zugeordneten Teilbereich fällt, und ihnen anderenfalls ein vorgegebener Intensitätswert zugeordnet wird. Die Vorrichtung umfaßt außerdem ein Emulationsmodul, dieses wandelt dann die Serie von Bildern in eine Serie von Zwischenbildern um, wobei für jedes der Zwischenbilder ein konstanter Wert der zweiten Eigenschaft in die Emulation eingeht. Der konstante Wert der zweiten Eigenschaft stammt aus dem jeweiligen Teilbereich und ist von den Werten der zweiten Eigenschaft für die jeweils Zwischenbilder verschieden. Anschließend erzeugt das Emulationsmodul durch Kombination der Zwischenbilder ein Emulationsbild. Auf diese Weise läßt sich der Einfluß der zweiten Eigenschaft auf das Abbildungsverhalten im Emulationsbild ortsaufgelöst berücksichtigen.

Bevorzugt ist der vorgegebene Intensitätswert Null, was die Auswertung vereinfacht. Auch ist es zweckmäßig, wenn sich die Teilbereiche teilweise überlappen, je nach dem welche Wichtungsfunktion die Vorrichtung verwendet.

Bevorzugt erzeugt die Vorrichtung eine Serie von Bildern und eine Serie von Zwischenbildern jeweils gleicher Größe, da dies die Handhabbarkeit erheblich vereinfacht und keine Schwierigkeiten bei der Aufteilung der Intensitätswerte auf die Bilder bzw. Zwischenbilder entstehen. Selbstverständlich ist es bei entsprechender Anpassung auch möglich, verschiedene Bildgrößen zu verwenden. Bevorzugt addiert die Vorrichtung die Intensitätswerte der Zwischenbilder für jeden Bildpunkt und erzeugt so das Emulationsbild. Dies ist die einfachste Methode, um die Ortsabhängigkeit der zweiten Größe bzw. deren Variabilität über das Bildfeld im Emulationsbild zu berücksichtigen. Alternativ kann die Vorrichtung auch für jeden Bildpunkt den Mittelwert der Intensitätswerte der Zwischenbilder bilden und auf diese Weise das Emulationsbild erzeugen. Bevorzugt wichtet die Vorrichtung dabei die Intensitätswerte bei der Zuordnung zu einem Bild der Serie, was insbesondere dann von Vorteil ist, wenn sich die Teilbereiche überlappen und ein Intensitätswert mehreren Teilbereichen zugeordnet werden kann.

In einer bevorzugten Ausgestaltung der Vorrichtung ist die zweite Eigenschaft die Farbe, wobei im Speichermodul für jeden Bildpunkt die Wellenlänge und/oder der Farbsättigungsgrad gespeichert werden. Diese Eigenschaft läßt sich mit Hilfe moderner Detektoren auf CCD- oder CMOS-Basis relativ leicht detektieren, wobei beispielsweise vorgesehen sein kann, für jeden Bildpunkt die Farbbereiche Rot, Grün und Blau einzeln auf je einer CCD mit Hilfe entsprechender Optiken zu detektieren.

Die Farbe ist jedoch nicht die einzige Wahl für die zweite Eigenschaft. Auch andere Eigenschaften, die nicht notwendigerweise sofort sichtbar sein müssen, kommen in Frage. Eine wichtige zweite Eigenschaft, insbesondere im Hinblick auf die Emulation hochaperturiger Abbildungsoptiken mit niederaperturigen Abbildungsoptiken, ist der Polarisationszustand. Hier wird im Speichermodul für jeden Bildpunkt der Polarisationsgrad und/oder Polarisationsrichtung gespeichert. Dabei kann bei der Vorrichtung ein Polarisator vorgesehen sein, durch den das Licht vor Detektion geleitet wird. Die Teilbereiche werden dabei durch verschiedene Stellungen des Polarisators festgelegt. Auf diese Weise kann die Serie von Bildern direkt erzeugt werden. Eine andere Möglichkeit besteht darin, die Serie von Bildern rechnerisch anhand der gespeicherten Werte zu erzeugen. Hierbei werden für jeden Bildpunkt am Anfang Polarisationsgrad und/oder -richtung gespeichert. Auch eine Kombination von Polarisator und rechnerischer Auswertung ist möglich.

Bevorzugt ordnet die Vorrichtung außerdem einem der Teilbereiche ausschließlich den Polarisationsgrad Null zu. Dem diesen Teilbereich zugeordneten Bild ordnet sich dann die Intensitätswerte von detektiertem, unpolarisiertem Licht zu.

In einer besonders bevorzugten Ausgestaltung der Erfindung ist bei der Vorrichtung als erste Abbildungsoptik ein Photolithographie-Scanner und als zweite Abbildungsoptik eine Emulationsabbildungsoptik zur Emulation des Photolithographie-Scanners vorgesehen. Auf diese Weise lassen sich mit der Emulationsabbildungsoptik die Polarisationseigenschaften des Photolithographie-Scanners ortsaufgelöst emulieren, obwohl das zugrundeliegende, im Emulationsmodul implementierte Emulationsverfahren diese Ortsabhängigkeit nicht berücksichtigen kann.

Die Erfindung soll im folgenden anhand eines Ausführungsbeispiels näher erläutert werden.

In den dazugehörigen Zeichnungen zeigt

Fig.1 eine beispielhafte Vorrichtung und
Fig.2 den Ablauf des Verfahrens.

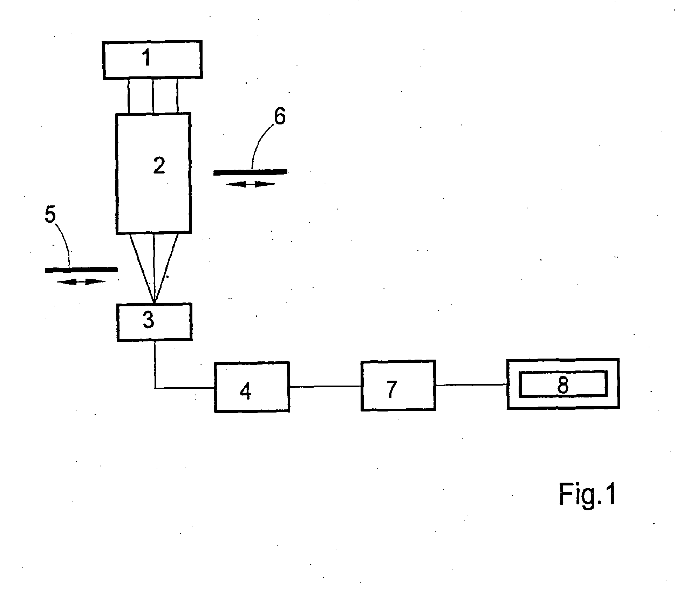

In Fig.1 ist eine Vorrichtung gezeigt, wie sie zur Untersuchung des Abbildungsverhaltens einer - nichtgezeigten - ersten Abbildungsoptik verwendet werden kann. Von einer Lichtquelle 1 wird Licht in eine zweite Abbildungsoptik 2 eingespeist. Die zweite Abbildungsoptik 2 fokussiert das Licht auf einen ortauflösenden Detektor 3 mit Pixeln. Das Licht wird in der Bildebene in den Pixeln detektiert. In den Pixeln direkt detektiert wird die Intensität. Die Werte für die Intensität werden in einem Speichermodul 4 in Zuordnung zu den Bildpunkten gespeichert. Außerdem wird in dem Speichermodul 4 noch eine zweite Eigenschaft des Lichts gespeichert. Dies kann beispielsweise die Farbe sein, oder aber auch die Polarisation. Im letzteren Fall kann beispielsweise ein in den Strahlengang vor den Detektor einschiebbarer, drehbarer Polarisator 5 vorgesehen sein. Die zweite Abbildungsoptik 2 bildet dabei ein Objekt 6 auf den Detektor 3 ab. Dazu wird das Objekt 6 an entsprechender Stelle in die zweite Abbildungsoptik 2 eingebracht, so daß ein Bild des Objektes 6 auf dem Detektor 3 erzeugt wird. Bei dem Objekt 6 kann es sich beispielsweise um einen einfachen oder nichtlinearen Farbfilter, einen Polarisator oder ein diffraktives optisches Element handeln. Im letzteren Fall muß unter Umständen die Einstellung der zweiten Abbildungsoptik an die Abbildungseigenschaften des Objektes 6 angepaßt werden. Schließlich kann es sich bei dem Objekt 6 auch um eine Maske handeln, wie sie in der Photolithographie verwendet wird. Bei der Lichtquelle 1 handelt es sich in diesem Fall bevorzugt um eine Quelle, die nur eine Wellenlänge aussendet. Falls es sich bei der zweiten Eigenschaft, die registriert werden soll, um die Polarisation oder nicht direkt sichtbare Eigenschaften handelt, so sind weitere Einrichtungen notwendig, die hier nicht gezeigt sind und der Detektion und Bestimmung dieser Eigenschaften dienen. Die Werte dieser Eigenschaften werden dann ebenfalls in Zuordnung zu den Bildpunkten im Speichermodul 4 gespeichert.

Die für die Intensität und die zweite Eigenschaft, beispielsweise die Polarisation, gespeicherten Werte werden anschließend von einem Emulationsmodul 7 verarbeitet. Im Emulationsmodul 7 wird ein Emulationsbild erzeugt, welches auf einen Bildschirm 8 dargestellt wird. Zusätzlich kann das Bild auch gespeichert werden oder/und ausgedruckt werden.

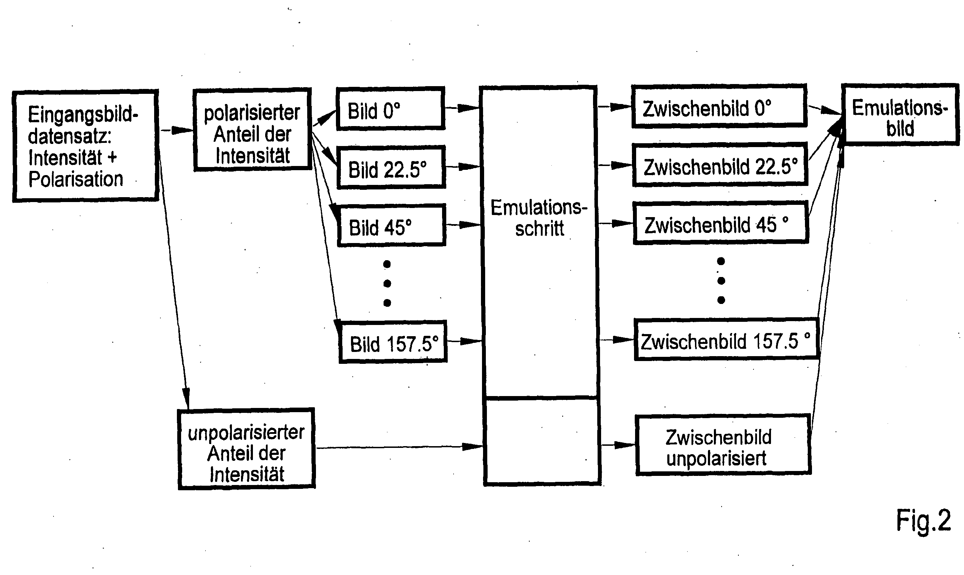

Die Erzeugung des Emulationsbildes ist in Fig. 2 skizziert. Für jeden Bildpunkt sind Intensität und Polarisation, d.h. Polarisationsgrad und/oder -richtung gespeichert. Diese Daten bilden den sogenannten Eingangsbilddatensatz. Aus diesem Eingangsbilddatensatz wird eine Serie von Bildern erzeugt. Dabei kann zunächst das Minimum und das Maximum der zweiten Eigenschaft bestimmt werden, um so den Wertebereich dieser Eigenschaft festzulegen. Dieser Wertebereich wird dann in Teilbereiche zerlegt, wobei der unpolarisierte Anteil der Intensität im Beispiel einem gesonderten Teilbereich mit dem Polarisationsgrad Null zugeordnet wird. Dieser Teilbereich enthält auch die Intensitätswerte des zirkular polarisierten Anteils des Lichts. Selbstverständlich ist die Zuordnung zu einem eigenen Teilbereich nicht zwingend. Der unpolarisierte Anteil kann beispielsweise auch auf die anderen Teilbereiche aufgeteilt werden - dies entspricht einer gleichmäßigen Aufteilung auf die einzelnen Bilder. Die weiteren Teilbereiche werden, nach Polarisationswinkeln in einem Wertebereich von 0° bis 180° aufgeteilt. Im vorliegenden Beispiel ist zu jedem Bild der Polarisationswinkel $\phi$ im Zentrum des entsprechenden Teilbereichs angegeben. Die Teilbereiche können dabei überlappend oder nichtüberlappend in Abstimmung mit der zu verwendenden Wichtungsfunktion gewählt werden. Im vorliegenden Beispiel werden acht Teilbereiche gewählt. Die Bilder werden anschließend im Emulationsschritt verarbeitet. Dabei wird eine Abbildung des Objektes 6 mit der ersten Abbildungsoptik unter Berücksichtigung der Abbildungseigenschaft und des Einflusses der Polarisation auf das Abbildungsverhalten emuliert. Die unpolarisierte Intensität kann dabei gesondert behandelt werden, muß aber nicht. Auch eine Aufteilung auf die polarisierten Bilder ist beispielsweise möglich. Handelt es sich bei dem Objekt 6 beispielsweise um eine Maske, so läßt sich eine Abbildung dieser Maske mit einem Photolithographiescanner als erster Abbildungsoptik emulieren. Bei der zweiten Abbildungsoptik 2 handelt es sich in diesem Fall um eine Emulationsabbildungsoptik. Die Abbildungseigenschaften, in denen sich beide Optiken unterscheiden, sind die Vergrößerung und die numerische Apertur. Bei der Verarbeitung im Emulationsschritt werden für jeden Polarisationswinkel $\phi$ Zwischenbilder erzeugt, wobei im Emulationsschritt die Polarisation für das jeweilige Bild als konstant angenommen wurde. Dies ist technisch bedingt, da die im Stand der Technik zur Verfügung stehenden Verfahren zur Emulation bzw. Berücksichtigung der Polarisation nur konstante Polarisationen berücksichtigen können. Zum Schluß werden die Zwischenbilder im vorliegenden Beispiel zum Emulationsbild bildpunktweise addiert. Auf diese Weise kann die Ortsabhängigkeit in der Polarisation bei der Emulation eines Photolithographiescanners berücksichtigt werden, obwohl das zur Verfügung stehende Emulationsverfahren nach dem Stand der Technik dies eigentlich nicht gestattet bzw. zu größeren Fehlern führt.

**Bezugszeichenliste**

1    Lichtquelle

2    zweite Abbildungsoptik

3    Detektor

4    Speichermodul

5    Polarisator

6    Objekt

7    Emulationsmodul

8    Bildschirm

**Patentansprüche**

1. Verfahren zur Untersuchung des Abbildungsverhaltens einer ersten Abbildungsoptik, bei dem ein Objekt (6) durch eine zweite Abbildungsoptik (2) in eine Bildebene abgebildet wird und Licht in der Bildebene in Pixeln ortsaufgelöst detektiert wird, wobei sich die erste und zweite Abbildungsoptik (2) in mindestens einer Abbildungseigenschaft unterscheiden,

   - wobei für jedes Pixel Werte für die Intensität als eine erste Eigenschaft des Lichts bestimmt und in Bildpunkten gespeichert werden, und
   - eine Serie von Bildern erzeugt wird,
   - **dadurch gekennzeichnet, daß**
   - für jedes Pixel Werte für mindestens eine weitere, zweite Eigenschaft des Lichts bestimmt und in Bildpunkten gespeichert werden,
   - die Serie von Bildern erzeugt wird, indem

      a. ein Wertebereich der zweiten Eigenschaft in Teilbereiche zerlegt wird,
      b. jedem Teilbereich ein Bild zugeordnet wird, und
      c. den Bildpunkten jedes Bildes der entsprechende, gespeicherte Intensitätswert zugeordnet wird, falls der dem Bildpunkt zugeordnete Wert der zweiten Eigenschaft in den dem jeweiligen Bild zugeordneten Teilbereich fällt, und ihnen andernfalls ein vorgegebener Intensitätswert zugeordnet wird,

- die gespeicherten Werte in einem Emulationsschritt verarbeitet werden, indem die Serie von Bildern in eine Serie von Zwischenbildern umgewandelt wird, wobei für jedes der Zwischenbilder ein konstanter Wert der zweiten Eigenschaft in die Emulation eingeht, der aus dem jeweiligen Teilbereich stammt und von den Werten der zweiten Eigenschaft für die jeweils anderen Zwischenbilder verschieden ist, und
- anschließend durch Kombination der Zwischenbilder ein Emulationsbild erzeugt wird, welches eine Abbildung des Objektes (6) mit der ersten Abbildungsoptik unter Berücksichtigung der Abbildungseigenschaft und des Einflusses der zweiten Eigenschaft auf das Abbildungsverhalten emuliert.

2. Verfahren nach Anspruch 1, **dadurch gekennzeichnet, daß** sich die Teilbereiche teilweise überlappen.

3. Verfahren nach Anspruch 1 oder 2, **dadurch gekennzeichnet, daß** der vorgegebene Intensitätswert Null ist.

4. Verfahren nach einem der vorgenannten Ansprüche, **dadurch gekennzeichnet, daß** sowohl die Bilder als auch die Zwischenbilder jeweils die gleiche Größe aufweisen.

5. Verfahren nach Anspruch 4, **dadurch gekennzeichnet, daß** die Intensitätswerte der Zwischenbilder für jeden Bildpunkt addiert werden und so das Emulationsbild erzeugt wird.

6. Verfahren nach Anspruch 4, **dadurch gekennzeichnet, daß** für jeden Bildpunkt der Mittelwert der Intensitätswerte der Zwischenbilder gebildet und so das Emulationsbild erzeugt wird.

7. Verfahren nach einem der vorgenannten Ansprüche, **dadurch gekennzeichnet, daß** die Intensitätswerte bei der Zuordnung zu einem Bild der Serie gewichtet werden.

8. Verfahren nach einem der vorgenannten Ansprüche, **dadurch gekennzeichnet, daß** die zweite Eigenschaft der Polarisationszustand ist, wobei für jeden Bildpunkt der Polarisationsgrad und/oder die Polarisationsrichtung gespeichert werden.

9. Verfahren nach Anspruch 8, **dadurch gekennzeichnet, daß** die Serie von Bildern erzeugt wird, indem das Licht vor der Detektion durch einen Polarisator (5) geleitet wird, wobei die Teilbereiche durch verschiedene Stellungen des Polarisators (5) festgelegt werden.

10. Verfahren nach Anspruch 8, **dadurch gekennzeichnet, daß** die Serie von Bildern rechnerisch anhand der gespeicherten Werte erzeugt wird.

11. Verfahren nach Anspruch 10, **dadurch gekennzeichnet, daß** die Intensitätswerte mit einer Funktion

$$C \cdot |\varphi - \theta|$$

gewichtet werden, wenn der einem Bildpunkt zugeordnete Polarisationswinkel $\theta$ in den Teilbereich fällt, wobei C eine Konstante und $\varphi$.der Polarisationswinkel im Zentrum des entsprechenden Teilbereichs ist.

12. Verfahren nach Anspruch 10, **dadurch gekennzeichnet, daß** die Intensitätswerte mit der Funktion

$$C \cdot \cos^2(\varphi - \theta)$$

gewichtet werden, wenn der einem Bildpunkt zugeordnete Polarisationswinkel $\theta$ in den Teilbereich fällt, wobei C eine Konstante und $\varphi$ der Polarisationswinkel im Zentrum des entsprechenden Teilbereichs ist.

13. Verfahren nach einem der Ansprüche 8 bis 12, **dadurch gekennzeichnet, daß** einem der Teilbereiche ausschließlich der Polarisationsgrad Null zugeordnet wird und dem diesem Teilbereich zugeordneten Bild die Intensitätswerte von detektiertem, unpolarisierten Licht zugeordnet werden.

14. Verfahren nach Anspruch 13, **dadurch gekennzeichnet, daß** die dem Bild mit dem Polarisationsgrad Null zugeordneten Intensitätswerte auf andere Bilder aufgeteilt und zu den entsprechenden Intensitätswerten addiert werden, wobei die Aufteilung vorzugsweise gleichmäßig erfolgt.

15. Verfahren nach einem der Ansprüche 1 bis 7, **dadurch gekennzeichnet, daß** die zweite Eigenschaft die Farbe ist, wobei für jeden Bildpunkt die Wellenlänge und/oder der Farbsättigungsgrad gespeichert werden.

16. Verfahren nach einem der vorgenannten Ansprüche, **dadurch gekennzeichnet, daß** als erste Abbildungsoptik ein Photolithographiescanner und als zweite Abbildungsoptik (2) eine Emulationsabbildungsoptik zur Emulation des Photolithographiescanners verwendet wird.

**17.** Vorrichtung zur Untersuchung des Abbildungsverhaltens einer ersten Abbildungsoptik, umfassend

- eine zweite Abbildungsoptik (2), durch die ein Objekt (6) in eine Bildebene abgebildet wird, und die sich von der ersten Abbildungsoptik in mindestens einer Abbildungseigenschaft unterscheidet,
- einen ortsauflösenden Detektor (3) mit Pixeln, mit dem Licht in der Bildebene in den Pixeln detektiert wird,
- ein Speichermodul (4), in welchem ortsaufgelöst Werte für die Intensität als eine erste Eigenschaft des Lichts in Bildpunkten gespeichert werden,
- wobei die Vorrichtung eine Serie von Bildern erzeugt,
- **dadurch gekennzeichnet, daß**
- im Speichermodul (4) ortsaufgelöst Werte für mindestens eine weitere, zweite Eigenschaft des Lichts in Bildpunkten gespeichert werden,
- die Vorrichtung die Serie von Bildern erzeugt, indem

a. ein Wertebereich der zweiten Eigenschaft in Teilbereiche aufgeteilt wird,
b. jedem Teilbereich ein Bild zugeordnet wird, und
c. den Bildpunkten jedes Bildes der entsprechende, gespeicherte Intensitätswert zugeordnet wird, falls der dem Bildpunkt zugeordnete Wert der zweiten Eigenschaft in den dem jeweiligen Bild zugeordneten Teilbereich fällt, und ihnen andernfalls ein vorgegebener Intensitätswert zugeordnet wird,

- die Vorrichtung außerdem ein Emulationsmodul (7) umfaßt, welches die Serie von Bildern in eine Serie von Zwischenbildern umwandelt, wobei für jedes der Zwischenbilder ein konstanter Wert der zweiten Eigenschaft in die Emulation eingeht, der aus dem jeweiligen Teilbereich stammt und von den Werten der zweiten Eigenschaft für die jeweils anderen Zwischenbilder verschieden ist, und
- das Emulationsmodul (7) durch Kombination der Zwischenbilder ein Emulationsbild erzeugt, welches eine Abbildung des Objektes (6) mit der ersten Abbildungsoptik unter Berücksichtigung der Abbildungseigenschaft und des Einflusses der zweiten Eigenschaft auf das Abbildungsverhalten emuliert.

**18.** Vorrichtung nach Anspruch 17, **dadurch gekennzeichnet, daß** sich die Teilbereiche teilweise überlappen.

**19.** Vorrichtung nach Anspruch 17 oder 18, **dadurch gekennzeichnet, daß** der vorgegebene Intensitätswert Null ist.

**20.** Vorrichtung nach einem der Ansprüche 17 bis 19, **dadurch gekennzeichnet, daß** sie eine Serie von Bildern und eine Serie von Zwischenbildern jeweils gleicher Größe erzeugt.

**21.** Vorrichtung nach einem der Ansprüche 17 bis 20, **dadurch gekennzeichnet, daß** sie die Intensitätswerte der Zwischenbilder für jeden Bildpunkt addiert und so das Emulationsbild erzeugt.

**22.** Vorrichtung nach einem der Ansprüche 17 bis 20, **dadurch gekennzeichnet, daß** sie für jeden Bildpunkt den Mittelwert der Intensitätswerte der Zwischenbilder bildet und so das Emulationsbild erzeugt.

**23.** Vorrichtung nach einem der Ansprüche 17 bis 22, **dadurch gekennzeichnet, daß** sie die Intensitätswerte bei der Zuordnung zu einem Bild der Serie wichtet.

**24.** Vorrichtung nach einem der Ansprüche 17 bis 23, **dadurch gekennzeichnet, daß** die zweite Eigenschaft der Polarisationszustand ist, wobei im Speichermodul für jeden Bildpunkt der Polarisationsgrad und/oder die Polarisationsrichtung gespeichert werden.

**25.** Vorrichtung nach Anspruch 24, **dadurch gekennzeichnet, daß** ein Polarisator (5) vorgesehen ist, durch den das Licht vor der Detektion geleitet wird, wobei die Teilbereiche durch verschiedene Stellungen des Polarisators (5) festgelegt werden.

**26.** Vorrichtung nach Anspruch 24, **dadurch gekennzeichnet, daß** sie die Serie von Bildern rechnerisch anhand der gespeicherten Werte erzeugt.

**27.** Vorrichtung nach einem der Ansprüche 24 bis 26, **dadurch gekennzeichnet, daß** sie einem der Teilbereiche ausschließlich den Polarisationsgrad Null und dem diesem Teilbereich zugeordneten Bild die Intensitätswerte von detektiertem, unpolarisierten Lichts zuordnet.

**28.** Vorrichtung nach einem der Ansprüche 17 bis 23, **dadurch gekennzeichnet, daß** die zweite Eigenschaft die Farbe ist, wobei im Speichermodul (4) für jeden Bildpunkt die Wellenlänge und/oder die Farbsättigung gespeichert werden.

**29.** Vorrichtung nach einem der Ansprüche 17 bis 28, **dadurch gekennzeichnet, daß** als erste Abbildungsoptik ein Photolithographiescanner und als zweite Abbildungsoptik (2) eine Emulationsabbildungsoptik zur Emulation des Photolithographiescanners vorgesehen ist.

**Claims**

1. Method for studying the imaging behaviour of first imaging optics, in which an object (6) is imaged by second imaging optics (2) into an image plane and light in the image plane is detected with spatial resolution in pixels, the first and second imaging optics (2) differing in at least one imaging property,

   - values of the intensity as a first property of the light being determined for each pixel and stored in image points, and
   - a series of images being produced,
   - **characterised in that**
   - values of at least one further second property of the light are determined for each pixel and stored in image points,
   - the series of images is produced by

      a. decomposing a value range of the second property into subranges,
      b. assigning an image to each subrange, and
      c. assigning the corresponding stored intensity value to the image points of each image if the value of the second property, assigned to the image point, falls within the subrange assigned to the respective image, and otherwise assigning a predetermined intensity value to them,

   - the stored values are processed in an emulation step by converting the series of images into a series of intermediate images, the emulation being provided with a constant value of the second property for each of the intermediate images, which is taken from the respective subrange and is different from the values of the second property for the respective other intermediate images, and
   - subsequently, by combination of the intermediate images, an emulation image is produced which emulates imaging of the object (6) by the first imaging optics while taking into account the imaging property and the effect of the second property on the imaging behaviour.

2. Method according to Claim 1, **characterised in that** the subranges partially overlap.

3. Method according to Claim 1 or 2, **characterised in that** the predetermined intensity value is zero.

4. Method according to one of the preceding claims, **characterised in that** both the images and the intermediate images respectively have the same size.

5. Method according to Claim 4, **characterised in that** the intensity values of the intermediate images are added for each image point, and the emulation image is produced in this way.

6. Method according to Claim 4, **characterised in that** the average value of the intensity values of the intermediate images is formed for each image point, and the emulation image is produced in this way.

7. Method according to one of the preceding claims, **characterised in that** the intensity values are weighted for the assignment to an image of the series.

8. Method according to one of the preceding claims, **characterised in that** the second property is the polarisation state, the degree of polarisation and/or the polarisation direction being stored for each image point.

9. Method according to Claim 8, **characterised in that** the series of images is produced by sending the light through a polariser (5) before the detection, the subranges being established by different settings of the polariser (5).

10. Method according to Claim 8, **characterised in that** the series of images is produced computationally with the aid of the stored values.

11. Method according to Claim 10, **characterised in that** the intensity values are weighted with a function

$$C \cdot | \varphi - \theta |,$$

when the polarisation angle $\theta$ assigned to an image point falls within the subrange, where C is a constant and $\theta$ is the polarisation angle at the centre of the corresponding subrange.

12. Method according to Claim 10, **characterised in that** the intensity values are weighted with the function

$$C \cdot \cos^2 (\varphi - \theta),$$

when the polarisation angle $\theta$ assigned to an image point falls within the subrange, where C is a constant and $\varphi$ is the polarisation angle at the centre of the corresponding subrange.

**13.** Method according to one of Claims 8 to 12, **characterised in that** exclusively the degree of polarisation zero is assigned to one of the subranges, and the intensity values of detected unpolarised light are assigned to the image assigned to this subrange.

**14.** Method according to Claim 13, **characterised in that** the intensity values assigned to the image with the degree of polarisation zero are distributed between other images and added to the corresponding intensity values, the distribution preferably being carried out uniformly.

**15.** Method according to one of Claims 1 to 7, **characterised in that** the second property is the colour, and the wavelength and/or the degree of colour saturation are stored for each image point.

**16.** Method according to one of the preceding claims, **characterised in that** a photolithography scanner is used as the first imaging optics and emulation imaging optics for emulating the photolithography scanner are used as the second imaging optics (2).

**17.** Device for studying the imaging behaviour of first imaging optics, comprising

- second imaging optics (2), by which an object (6) is imaged into an image plane and which differs from the first imaging optics in at least one imaging property,
- a spatially resolving detector (3), which has pixels and by which light in the image plane is detected in the pixels,
- a storage module (4), in which the values of the intensity as a first property of the light are stored with spatial resolution in image points,
- the device producing a series of images,
- **characterised in that**
- values of at least one further second property of the light are stored with spatial resolution in image points in the storage module (4),
- the device produces a series of images by

a. decomposing a value range of the second property into subranges,
b. assigning an image to each subrange, and
c. assigning the corresponding stored intensity value to the image points of each image if the value of the second property, assigned to the image point, falls within the subrange assigned to the respective image, and otherwise assigning a predetermined intensity value to them,

- the device furthermore comprises an emulation module (7) which converts the series of images into a series of intermediate images, the emulation being provided with a constant value of the second property for each of the intermediate images, which is taken from the respective subrange and is different from the values of the second property for the respective other intermediate images, and
- by combination of the intermediate images, the emulation module (7) produces an emulation image which emulates imaging of the object (6) by the first imaging optics while taking into account the imaging property and the effect of the second property on the imaging behaviour.

**18.** Device according to Claim 17, **characterised in that** the subranges partially overlap.

**19.** Device according to Claim 17 or 18, **characterised in that** the predetermined intensity value is zero.

**20.** Device according to one of Claims 17 to 19, **characterised in that** it produces a series of images and a series of intermediate images respectively of the same size.

**21.** Device according to one of Claims 17 to 20, **characterised in that** it adds the intensity values of the intermediate images for each image point, and produces the emulation image in this way.

**22.** Device according to one of Claims 17 to 20, **characterised in that** it forms the average value of the intensity values of the intermediate images for each image point, and produces the emulation image in this way.

**23.** Device according to one of Claims 17 to 22, **characterised in that** it weights the intensity values for the assignment to an image of the series.

**24.** Device according to one of Claims 17 to 23, **characterised in that** the second property is the polarisation state, the degree of polarisation and/or the polarisation direction being stored in the storage module for each image point.

**25.** Device according to Claim 24, **characterised in that** a polariser (5) is provided, through which the light is sent before the detection, the subranges being established by different settings of the polariser (5).

**26.** Device according to Claim 24, **characterised in that** it produces the images computationally with the aid of the stored values.

**27.** Device according to one of Claims 24 to 26, **characterised in that** it assigns exclusively the degree of polarisation zero to one of the subranges, and it assigns the intensity values of detected unpolarised light to the image assigned to this subrange.

28. Device according to one of Claims 17 to 23, **characterised in that** the second property is the colour, and the wavelength and/or the degree of colour saturation are stored in the storage module (4) for each image point.

29. Device according to one of Claims 17 to 28, **characterised in that** a photolithography scanner is provided as the first imaging optics and emulation imaging optics for emulating the photolithography scanner are provided as the second imaging optics (2).

**Revendications**

1. Procédé pour étudier le comportement à la reproduction d'une première optique de reproduction, dans lequel un objet (6) est reproduit par une seconde optique de reproduction (2) dans un plan d'image et dont la lumière est détectée dans le plan d'image, avec une résolution locale en pixels, la première et la seconde optique de reproduction (2) se différenciant dans au moins une propriété de reproduction,

   - des valeurs pour l'intensité étant déterminées pour chaque pixel en tant qu'une première propriété de la lumière et étant mémorisées en points d'image, et
   - une série d'images est générée,
   - **caractérisé en ce que**
   - des valeurs pour au moins une autre seconde propriété de la lumière sont déterminées pour chaque pixel et mémorisées en points d'image,
   - la série d'images est générée, par le fait

      a. qu'une plage de valeurs de la seconde propriété est décomposée en plages partielles,
      b. qu'une image est attribuée à chaque plage partielle, et
      c. que la valeur d'intensité mémorisée correspondante est attribuée aux points d'image de chaque image dans le cas où la valeur, attribuée au point d'image, de la seconde propriété tombe dans la plage partielle attribuée à l'image respective, et une valeur d'intensité prédéfinie leur est attribuée autrement,

   - les valeurs mémorisées sont traitées dans une étape d'émulation, par le fait que la série d'images est transformée en une série d'images intermédiaires, une valeur constante de la seconde propriété étant prise en compte dans l'émulation pour chacune des images intermédiaires, laquelle valeur provient de la plage partielle respective et est différente des valeurs de la seconde propriété pour les autres images intermédiaires respectives, et
   - une image d'émulation est générée ensuite par combinaison des images intermédiaires, laquelle image émule une reproduction de l'objet (6) avec la première optique de reproduction en tenant compte de la propriété de reproduction et de l'influence de la seconde propriété sur le comportement à la reproduction.

2. Procédé selon la revendication 1, **caractérisé en ce que** les plages partielles se chevauchent partiellement.

3. Procédé selon la revendication 1 ou 2, **caractérisé en ce que** la valeur d'intensité prédéfinie est zéro.

4. Procédé selon l'une des revendications susmentionnées, **caractérisé en ce qu'**aussi bien les images que les images intermédiaires présentent à chaque fois la même grandeur.

5. Procédé selon la revendication 4, **caractérisé en ce que** les valeurs d'intensité des images intermédiaires sont cumulées pour chaque point d'image et l'image d'émulation est générée ainsi.

6. Procédé selon la revendication 4, **caractérisé en ce que** la valeur moyenne des valeurs d'intensité des images intermédiaires est formée pour chaque point d'image et l'image d'émulation est générée ainsi.

7. Procédé selon l'une des revendications précédentes **caractérisé en ce que** les valeurs d'intensité sont pondérées lors de l'attribution à une image de la série.

8. Procédé selon l'une des revendications précédentes, **caractérisé en ce que** la seconde propriété est l'état de polarisation, le degré de polarisation et/ou le sens de polarisation étant mémorisés pour chaque point d'image.

9. Procédé selon la revendication 8, **caractérisé en ce que** la série d'images est générée du fait que la lumière est dirigée avant la détection par un polariseur (5), les plages partielles étant définies par différentes positions du polariseur (5).

10. Procédé selon la revendication 8, **caractérisé en ce que** la série d'images est générée par ordinateur à l'aide des valeurs mémorisées.

11. Procédé selon la revendication 10, **caractérisé en**

**ce que** les valeurs d'intensité sont pondérées avec une fonction

$$C \cdot |\varphi - \theta|$$

lorsque l'angle de polarisation θ, attribué à un point d'image, tombe dans la plage partielle, C étant une constante et φ l'angle de polarisation au centre de la plage partielle correspondante.

**12.** Procédé selon la revendication 10, **caractérisé en ce que** les valeurs d'intensité sont pondérées avec la fonction

$$C \cdot cos^2(\varphi - \theta)$$

lorsque l'angle de polarisation θ, attribué à un point d'image, tombe dans la plage partielle, C étant une constante et φ l'angle de polarisation au centre de la plage partielle correspondante.

**13.** Procédé selon l'une des revendications 8 à 12, **caractérisé en ce que** seul le degré de polarisation zéro est attribué à l'une des plages partielles et les valeurs d'intensité de lumière détectée et non polarisée sont attribuées à l'image attribuée à cette plage partielle.

**14.** Procédé selon la revendication 13, **caractérisé en ce que** les valeurs d'intensité attribuées à l'image avec le degré de polarisation zéro sont réparties entre d'autres images et sont ajoutées aux valeurs d'intensité correspondantes, la répartition s'effectuant de préférence de façon uniforme.

**15.** Procédé selon l'une des revendications 1 à 7, **caractérisé en ce que** la seconde propriété est la couleur, la longueur d'image et/ou le degré de saturation de couleur étant mémorisés pour chaque point d'image.

**16.** Procédé selon l'une des revendications précédentes, **caractérisé en ce qu'**un scanner de photolithographie est utilisé comme première optique de reproduction et une optique de reproduction d'émulation est utilisée comme seconde optique de reproduction (2) pour l'émulation du scanner de photolithographie.

**17.** Dispositif pour étudier le comportement à la reproduction d'une première optique de reproduction, comprenant

    - une seconde optique de reproduction (2), par laquelle un objet (6) est reproduit dans un plan d'image, et qui se différencie de la première optique de reproduction dans au moins une propriété de reproduction,
- un détecteur (3) à résolution locale avec des pixels, qui permet de détecter de la lumière dans le plan d'image dans les pixels,
- un module de mémoire (4), dans lequel des valeurs pour l'intensité sont mémorisées avec une résolution locale en tant qu'une première propriété de la lumière en points d'image,
- le dispositif générant une série d'images, **caractérisé en ce que**
- des valeurs pour au moins une autre seconde propriété de la lumière sont mémorisées dans le module de mémoire (4) avec une résolution locale,
- le dispositif génère la série d'images par le fait que

    a. une plage de valeurs de la seconde propriété est divisée en plages partielles,
    b. une image est attribuée à chaque plage partielle, et
    c. la valeur d'intensité mémorisée correspondante est attribuée aux points d'image de chaque image si la valeur attribuée au point d'image de la seconde propriété tombe dans la plage partielle attribuée à l'image respective, et autrement une valeur d'intensité prédéfinie leur est attribuée,

- le dispositif comprend d'autre part un module d'émulation (7), qui transforme la série d'images en une série d'images intermédiaires, une valeur constante de la seconde propriété étant intégrée dans l'émulation pour chacune des images intermédiaires, laquelle valeur provient de la plage partielle respective et est différente des valeurs de la seconde propriété pour les autres images intermédiaires respectives, et
- le module d'émulation (7) génère par combinaison des images intermédiaires une image d'émulation, qui émule une reproduction de l'objet (6) avec la première optique de reproduction en tenant compte de la propriété de reproduction et de l'influence de la seconde propriété sur le comportement à la reproduction.

**18.** Dispositif selon la revendication 17, **caractérisé en ce que** les zones partielles se chevauchent partiellement.

**19.** Dispositif selon la revendication 17 ou 18, **caractérisé en ce que** la valeur d'intensité prédéfinie est zéro.

**20.** Dispositif selon l'une des revendications 17 à 19, **caractérisé en ce qu'**il génère une série d'images et une série d'images intermédiaires de grandeur respectivement identique.

21. Dispositif selon l'une des revendications 17 à 20, **caractérisé en ce qu'**il cumule les valeurs d'intensité des images intermédiaires pour chaque point d'image et génère ainsi l'image d'émulation.

22. Dispositif selon l'une des revendications 17 à 20, **caractérisé en ce qu'**il génère pour chaque point d'image la valeur moyenne des valeurs d'intensité des images intermédiaires et génère ainsi l'image d'émulation.

23. Dispositif selon l'une des revendications 17 à 22, **caractérisé en ce qu'**il pondère les valeurs d'intensité lors de l'attribution à une image de la série.

24. Dispositif selon l'une des revendications 17 à 23, **caractérisé en ce que** la seconde propriété est l'état de polarisation, le degré de polarisation et/ou le sens de polarisation étant mémorisé(s) dans le module de mémoire pour chaque point d'image.

25. Dispositif selon la revendication 24, **caractérisé en ce qu'**un polarisateur (5) est prévu, par lequel la lumière est dirigée avant la détection, les plages partielles étant définies par différentes positions du polarisateur (5).

26. Dispositif selon la revendication 24, **caractérisé en ce qu'**il génère la série d'images par ordinateur à l'aide des valeurs mémorisées.

27. Dispositif selon l'une des revendications 24 à 26, **caractérisé en ce qu'**il attribue exclusivement le degré de polarisation zéro à l'une des plages partielles et les valeurs d'intensité de la lumière détectée et non polarisée à l'image attribuée à cette plage partielle.

28. Dispositif selon l'une des revendications 17 à 23, **caractérisé en ce que** la seconde propriété est la couleur, la longueur d'onde et/ou la saturation de couleur étant mémorisée(s) dans le module de mémoire (4) pour chaque point d'image.

29. Dispositif selon l'une des revendications 17 à 28, **caractérisé en ce qu'**un scanner de photolithographie est prévu comme première optique de reproduction et une optique de reproduction d'émulation est prévue comme seconde optique de reproduction (2) pour l'émulation du scanner de photolithographie.

Fig.1

Fig.2

**IN DER BESCHREIBUNG AUFGEFÜHRTE DOKUMENTE**

**In der Beschreibung aufgeführte Patentdokumente**

- WO 03001272 A3
- WO 0376891 A
- DE 102004033603

**In der Beschreibung aufgeführte Nicht-Patentliteratur**

- **H. W. BERRY et al.** *Applied Optics,* 1977, vol. 16, 3200